# EUROPÄISCHE PATENTSCHRIFT

(11) **EP 0 923 001 B1**
(45) Veröffentlichungstag und Bekanntmachung des Hinweises auf die Patenterteilung: **07.12.2005**
(21) Anmeldenummer: 98123108.7
(22) Anmeldetag: 03.12.1998
(51) Int. Cl.: G03F 7/32

(54) **Verwendung eines Entwicklers zum Entwickeln von bestrahlten, strahlungsempfindlichen Aufzeichnungsmaterialien**
Use of a developer for developing radiation exposed photoimageable materials
Utilisation d'un développateur pour le developpement de matériaux photosensibles exposés aux radiations

(30) Priorität: 12.12.1997 DE 19755295
(43) Veröffentlichungstag der Anmeldung: 16.06.1999
(73) Patentinhaber: AGFA-GEVAERT, 2640 Mortsel (BE)
(72) Erfinder: Konrad, Klaus Peter, Dr. Dipl.-Chem., 55457 Gensingen (DE); Denzinger, Steffen Dr. Dipl.-Chem., 55128 Mainz (DE); Elsässer, Andreas, Dr. Dipl.-Chem., 65510 Idstein (DE)

(56) Entgegenhaltungen:
- EP-A- 0 180 122
- EP-A- 0 367 049
- EP-A- 0 368 214

## Beschreibung

Die Erfindung betrifft die Verwendung einer Zusammensetzung als Entwickler zum Entwickeln von bestrahlen, strahlungsempfindlichen Aufzeichnungsmaterialien, die Wasser und mindestens eine in wäßriger Lösung alkalisch reagierende Verbindung enthält. Die Zusammensetzung ist besonders geeignet zum Entwickeln von strahlungsempfindlichen Aufzeichnungsmaterialien, aus denen Offsetdruckplatten hergestellt werden.

An einen wäßrig-alkalischen Entwickler der eingangs genannen Art wird eine Reihe von Anforderungen gestellt: Er soll ergiebig sein. Das bedeutet, die Entwicklungsleistung soll auch nach längerem Gebrauch und dadurch gestiegener Belastung durch abgelöste Schichtbestandteile möglichst wenig abnehmen. Die sogenannte "Tongrenze", bei der der Entwickler verbraucht ist und die Schicht an den Nichtbildstellen nur noch unvollständig ablöst, soll so hoch wie möglich liegen. Selbstverständlich soll er die Aufzeichnungsmaterialien möglichst schnell und vollständig entwickeln. Dies ist besonders wichtig bei der maschinellen Herstellung der Druckplatten in Verarbeitungsstraßen. Bedingt durch kurze Taktzeiten kann eine Entwicklungsdauer von deutlich weniger als 30 s notwendig sein.

Aus ökologischen und ökonomischen Gründen ist es von Vorteil, wenn der Entwickler in Form eines flüssigen Konzentrats angeboten werden kann, das erst der Verbraucher mit Wasser verdünnt. Die Härte des Wassers ist regional verschieden, was aber die Eigenschaften des gebrauchsfertigen Entwicklers nicht beeinflussen soll. Daraus resultiert die Forderung nach einer geringen Empfindlichkeit gegen Wasserhärte.

Beim Entwickeln sollen sich weder Schaum noch feste Niederschläge bilden. Letztere könnten die Entwicklungsgeräte verunreinigen und damit einen erhöhten Wartungsaufwand verursachen oder sich sogar auf dem entwickelten Aufzeichnungsmaterial absetzen.

Außerdem muß die von mit Schichtresten beladene Entwicklerlösung mit den in der Verarbeitungsanlage verwendeten Gummierlösungen verträglich sein. Durch die unvermeidliche Verschleppung von belasteter Entwicklerlösung über durchlaufende Druckplatten kann es nach relativ kurzer Zeit zur Ansammlung von Schichtresten im nachgeschalteten Vorratsbehälter der Gummierlösung kommen. Im ungünstigsten Fall entstehen dadurch feste Niederschläge, die sich nach einer Phase der Anreicherung über das Walzensystem der Gummierstation auf der druckenden Oberfläche der entwickelten Druckplatte wieder absetzen ("redeponieren") und letztere dadurch unbrauchbar machen können.

In der EP-A 0 323 836 sind wäßrig-alkalische Entwickler für positiv und negativ arbeitende Aufzeichnungsmaterialien beschrieben. Sie enthalten neben einem alkalisch wirkenden Mittel einen Verdicker, der ihre Viskosität auf 5 bis 10.000 mPa·s (5 bis 10.000 cps) einstellt. Gegebenenfalls können die Entwickler auch organische Lösemittel wie Benzylalkohol oder Ethylenglykolmonophenylether enthalten. Entwickler für positiv arbeitende Aufzeichnungsmaterialien können darüber hinaus Tenside enthalten, insbesondere anionische oder amphotere Tenside. Als Verdicker dienen feine Silikatpulver oder wasserlösliche Polymere, wie Stärke, Gummi arabicum, Natriumalginat, Pektin, Viskose, Methylcellulose, Carboxymethylcellulose, Polyvinylalkohol, Polyvinylmethylether oder Polyvinylpyrrolidon.

Es sehr spezieller wäßrig-alkalischer Entwickler für negativ arbeitende Aufzeichnungsmaterialien zur Herstellung von Offsetdruckplatten ist in der EP-A 602 736 offenbart. Er erlaubt besonders kurze Entwicklungszeiten und verhindert übermäßige Ablagerungen in den Verarbeitungsgeräten. Darüber hinaus soll er bereits gebildete Ablagerungen schnell wieder auflösen. Er enthält ein organisches Lösemittel, ein anionisches Tensid, ein Alkalimetall-tetraborat, ein Alkalisalz einer aliphalischen Monocarbonsäure, ein Alkalisalz einer aliphalischen Dicarbonsäure, ein Alkalimetall-citrat, ein Poly(alkylenglykol), ein Alkalimetallsalz einer hydroxylierten aromatischen Carbon- oder sulfonsäure und ein alkalisches Puffersystem, das einen alkalischen pH-Wert gewährleistet.

Ein zur Herstellung von Negativ-Druckplatten geeigneter Entwickler ist auch Gegenstand der US-A 3 954 472. Er enthält Ammoniumsulfit und Polyvinylpyrrolidon gelöst in Wasser und einem Alkohol, insbesondere n-Propanol. Das Polyvinylpyrrolidon wirkt dabei als Gummierungsmittel.

Polyvinylpyrrolidon oder ein Copolymer mit Einheiten aus N-Vinyl-pyrrolidon wird auch in dem wäßrig-alkalischen Entwickler gemäß der DE-A 42 24 205 verwendet. Der Entwickler enthält daneben ein alkalisch wirkendes Mittel, wie NaOH, KOH, Na₂CO₃, K₂CO₃, Natrium- oder Kaliumsilikat, Trinatrium- oder Trikaliumphosphat. Gegebenenfalls kann noch ein Tensid vom Alkalimetallsulfat- oder Alkalimetallsulfonattyp, ein Antischaummittel sowie ein organisches Lösemittel, wie Benzylalkohol oder Ethylenglykol-monomethylether, -monoethylether, -monobutylether oder -monophenylether, zugefügt werden. Er ist speziell für die Entwicklung von Farbprüfmaterialien (= Color-Proof-Materialien) vorgesehen, wo er die Bildung von Farbschleiern in den Nichtbildbereichen verhindert.

In der EP-A 0 004 014 ist ein besonders ergiebiger Entwickler für Aufzeichnungsmaterialien mit belichteten, negativ arbeitenden Schichten aus Diazoniumsalz-polykondensationsprodukten und wasserunlöslichen organischen Polymeren offenbart. Er enthält ein anionisches Netzmittel, Polyvinylalkohol, Poly(N-Vinyl-N-methyl-acetamid), Benzylalkohol, Glycerintriacetat und einen Puffer, der einen pH-Wert im Bereich von 4 bis 8 gewährleistet. Da in diesem Entwickler nur hochsiedende organische Lösemittel verwendet werden, bleibt seine Zusammensetzung auch bei längerem Stehen in offenen Behältern praktisch konstant.

Mit dem wäßrig-alkalischen Entwickler gemäß der EP-A 0 180 122 lassen sich belichtete, negativ arbeitende Kopierschichten besonders schnell und gut entwickeln. Er hat darüber hinaus eine hohe Standzeit, ist in automatischen Entwicklungsmaschinen einsetzbar und verhindert die Bildung von Fladen und Fädchen aus abgelösten Schichtbestandteilen. Er enthält neben Wasser und einem alkalisch reagierenden Mittel einen Komplexbildner, ein anionisches Tensid, eine Alkansäure oder deren Salz, eine Puffersubstanz und einen Emulgator, der bevorzugt Poly(N-Vinyl-N-methyl-acetamid), Polyvinylalkohol, Dextrin, Gummi arabicum oder ein Celluloseether ist.

Die genannten polymeren Emulgatoren bewirken zwar eine wesentliche Verbesserung der Entwicklereigenschaften, haben jedoch auch Nachteile. So bestimmen sie wesentlich die Viskosität, d.h. sie bewirken selbst dann eine relativ hohe Viskosität, wenn sie nur in geringen Mengen im Entwickler enthalten sind. Eine möglichst niedrige Grundviskosität und eine moderate Viskositätserhöhung bei zunehmender Belastung des Entwicklers durch abgelöste Schichtbestandteile ist jedoch notwendig, um einerseits die mechanische Belastung von Bauteilen der Verarbeitungsanlage (Pumpen, Schlauchverbindungen) gering zu halten und andererseits einer frühzeitigen Verschlammung im Entwicklungsteil der Verarbeitungsmaschine und damit einem erhöhten Reinigungsaufwand beim Entwicklerwechsel entgegenzuwirken. Mit den bekannten Emulgatoren wird stets nur ein Kompromiß erreicht. Durch den stark viskositätssteigernden Effekt der bekannten Emulgatoren ist ihr Anteil in der Entwicklerlösung beschränkt.

Mit den bisher bekannten Entwicklern ließen sich die genannten Forderungen - keine Bildung von Fladen oder Fädchen durch abgelöste Schichtbestandteile in der Entwicklerstation oder in der nachfolgenden Gummierstation der Druckplattenverarbeitungsmaschine, dabei gleichzeitig geringe Grundviskosität und geringe Viskositätszunahme bei wachsender Belastung - nicht alle gleichzeitig erfüllen. Es bestand daher die Aufgabe, einen entsprechend verbesserten Entwickler für strahlungsempfindliche Aufzeichnungsmaterialien zur Verfügung zu stellen.

Überraschenderweise ließ sich diese Aufgabe lösen mit Emulgatoren, von denen nur einige bisher als Bestandteil von Flüssigwaschmitteln beschrieben sind.

Gegenstand der vorliegenden Erfindung ist somit die Verwendung einer Zusammensetzung als Entwickler zum Entwickeln von bestrahlten, strahlungsempfindlichen Aufzeichnungsmaterialien,wobei die Zusammensetzung Wasser und mindestens eine in wäßriger Lösung alkalisch reagierende Verbindung enthält und dadurch gekennzeichnet ist, daß sie mindestens ein als Emulgator wirkendes Copolymer enthält mit Einheiten aus
- (I): mindestens einer hydrophoben Vinylverbindung, die Alkylreste mit bis 30 Kohlenstoffatomen aufweist, und
- (II): mindestens einer hydrophilen, ethylenisch ungesättigten Carbonsäure, wobei ein Teil der Carboxygruppen in diesen Einheiten verestert ist mit Umsetzungsprodukten von
(A) (C₁-C₃₀)Alkanolen, (C₈-C₂₅)Alkansäuren, (C₁-C₁₂)Alkyl-phenolen, Di(C₁-C₁₀)alkylaminen mit
(B) (C₂-C₄)Alkylenoxiden oder Tetrahydrofuran,
wobei das Molverhältnis (A) : (B) im Bereich von 1 : 2 bis 1 : 50 liegt.

Bei der hydrophoben Vinylverbindung, die Alkylreste mit bis zu 30 C-Atomen aufweist, handelt es sich bevorzugt um geradkettige oder verzweigte Alkene, wobei sich die Doppelbindung in der Kohlenstoffkette oder an einem Ende davon befinden kann. Mit besonderem Vorteil lassen sich (C₄-C₂₈)Alkene einsetzen, z. B. Buten, Isobuten, 2,4,4-Trimethyl-penten, Hexen, Octen, Decen, Dodecen, Tetradecen, Octadecen, Eicosen, Docosen und andere, soweit sie polymerisierbar sind. Von diesen wiederum sind geradkettige und verzweigte Alkene mit 6 bis 10 Kohlenstoffatomen bevorzugt. Auch Gemische von Alkenen, insbesondere von verzweigten Alkenen, sind geeignet, z. B. von 2,4,4-Trimethyl-pent-1-en und 2,4,4-Trimethyl-pent-2-en (Diisobuten).

Die ethylenisch ungesättigten Carbonsäuren sind bevorzugt δ, β-ungesättigte Carbonsäuren mit 3 bis 8 C-Atomen. Es können Mono-, Di- oder Tricarbonsäuren sein, wobei (C₃-C₈)Monocarbonsäuren, wie Acrylsäure, Methacrylsäure oder Crotonsäure, und (C₄-C₈)Dicarbonsäuren, wie Maleinsäure, Itaconsäure, Methylenmalonsäure, Mesaconsäure oder Citraconsäure, bevorzugt sind. Bei der Herstellung der Copolymere können naturgemäß auch Säurederivate, insbesondere Säureanhydride, eingesetzt werden.

Geeignete (C₁-C₃₀)Alkanole (A) sind Methanol, Ethanol, Propanol, Isopropanol, Butanol, Isobutanol, sec.-Butanol, *tert*.-Butanol, Pentanol, Hexanol, 2-Ethyl-hexanol, Heptanol, Octanol, Decanol, Dodekanol, Tridecanol, Tetradecanol, Pentadecanol, Octadecanol, Eicosanol und Hexacosanol. Bevorzugt sind (C₁₀-C₁₅)-Alkanole, wie sie nach dem Oxoverfahren erhältlich sind (daher auch als "Oxoalkohole" bezeichnet).

Bevorzugte (C₈-C₂₅)Alkansäuren sind Octansäure (= Caprylsäure), Nonansäure (= Pelargonsäure), Decansäure (= Caprinsäure), Undecansäure, Dodecansäure (= Laurinsäure), Tridecansäure, Tetradecansäure (= Myristinsäure), Pentadecansäure, Hexadecansäure (= Palmitinsäure), Octadecansäure (= Stearinsäure), Eicosansäure (= Arachinsäure), Docosansäure (= Behensäure) und Tetracosansäure (= Lignocerinsäure).

Die (C₁-C₁₂)Alkyl-phenole (A) sind bevorzugt Methylphenol, Butylphenol, Isobutylphenol, Pentylphenol, Hexylphenol, Octylphenol, Nonylphenol, Decylphenol und Dodecylphenol, wobei sich die geradkettigen oder verzweigten Alkylgruppen vorzugsweise in *ortho*- oder *para*-Position zur phenolischen Hydroxygruppe befinden.

Geeignete Di(C₁-C₂₀)alkylamine (A) sind Dimethylamin, Ethyl-methyl-amin, Diethylamin, Dipropylamin, Ethyl-propyl-amin, Dibutylamin, Dipentylamin, Dioctylamin, Ethyl-octyl-amin, Didecylamin, Didodecylamin und Dioctadecylamin. Von diesen sekundären Aminen sind solche mit 8 bis 18 C-Atomen in jeder Alkylgruppe bevorzugt.

Als (C₂-C₄)Alkylenoxide (B) werden bevorzugt Ethylen- und Propylenoxid eingesetzt; aber auch Butylen- und Isobutylenoxid oder ein Gemisch davon sind verwendbar. Es ist auch möglich, die Umsetzung mit zwei oder mehr der genannten Alkylenoxide nacheinander durchzuführen, beispielsweise die Verbindungen (A) erst mit Ethylenoxid und dann mit Propylenoxid (oder umgekehrt) umzusetzen.

Von den Copolymeren sind solche bevorzugt, in denen 5 bis 50 %, besonders bevorzugt 10 bis 35 %, der Carboxygruppen der ethylenisch ungesättigten Carbonsäuren (II) verestert sind. Die Einheiten (I) und (II) sollten zusammen mindestens 50 mol-%, bevorzugt mindestens 70 mol-%, aller Einheiten im Copolymer ausmachen. Dabei sollten die Einheiten (II) einen Anteil von mindestens 5 mol-%, bevorzugt mindestens 10 mol-%, haben.

In einer bevorzugten Ausführungsform ist das als Emulgator wirkende Copolymer erhältlich durch Copolymerisation von (I) mindestens einem (C₄-C₂₈)Alken und
- (IIa): mindestens einem ethylenisch ungesättigten Dicarbonsäureanhydrid mit 4 bis 8 C-Atomen, wobei das Molverhältnis (I): (IIa) im Bereich von 7:3 bis 3:7 liegt, oder
- (IIb): mindestens einer ethylenisch ungesättigten Monocarbonsäuren mit 3 bis 8 C-Atomen, wobei das Molverhältnis (I) : (IIb) im Bereich von 1:1 bis 1:5 liegt,
anschließender partieller Veresterung der Carboxygruppen des Copolymers mit Umsetzungsprodukten von (A) (C₁-C₃₀)Alkanolen, (C₈-C₂₂)Fettsäuren, (C₁-C₁₂)-Alkyl-phenolen oder sekundären (C₂-C₃₀)Aminen mit (B) mindestens einem (C₂-C₄)Alkylenoxid oder Tetrahydrofuran, wobei das Molverhältnis (A) : (B) im Bereich von 1:2 bis 1:50 liegt, und Hydrolyse der Anhydridgruppen des Copolymers zu Carboxygruppen oder deren Salzen (bevorzugt Erdalkali- oder Alkalimetallsalzen, insbesondere K- oder Na-Salzen), wobei die partielle Veresterung so weit geführt wird, daß zwischen 5 und 50 % der Carboxygruppen des Copolymers verestert sind.

Die erfindungsgemäß verwendeten Copolymere sind auch durch Copolymerisation von (I) mit den Reaktionsprodukten von (IIa) oder (IIb) mit (A) und (B) im oben genannten Molverhältnis erhältlich. Die Copolymere können darüber hinaus bis zu 50 mol-% an anderen Einheiten enthalten, insbesondere solchen aus Amiden monoethylenisch ungesättigter (C₃-C₈)Carbonsäuren, deren Amidgruppen der Formel

-CO-NR¹R²

entsprechen, worin
- R¹: eine (C₈-C₂₈)Alkylgruppe oder eine Gruppe der Formel RO-[CHR³-CHR⁴-O]ₙ₋₁-CHR³-CHR⁴- und
- R²: ein Wasserstoffatom oder eine der Gruppen R¹ bedeutet,
- R³, R⁴: gleich oder verschieden sind und ein Wasserstoffatom, eine Methyl- oder eine Ethylgruppe bedeuten,
- R: eine (C₁-C₂₈)Alkylgruppe und
- n: eine ganze Zahl von 2 bis 100 bedeutet.

Solche Polymere sind in der EP-A 0 368 214 und EP-A 0 367 049 als Zusätze zu Flüssigwaschmitteln beschrieben.

Die in dem erfindungsgemäß verwendeten Entwickler eingesetzten Copolymere besitzen allgemein K-Werte von 6 bis 200, bevorzugt 10 bis 80 (bestimmt nach H. Fikentscher in 1 %iger wäßriger Lösung bei 25°C und pH 7,5 in Form des Natriumsalzes), entsprechend einem mittleren Molekulargewicht (M_{w}) von 500 bis 500.000, bevorzugt 1.000 bis 150.000. Die Monomereinheiten sind darin in der Regel statistisch verteilt; die Copolymere sind also keine Blockcopolymere.

Als Komponente (IIa) sind monoethylenisch ungesättigte Dicarbonsäureanhydride mit 4 bis 8 C-Atomen, wie Maleinsäureanhydrid, Itaconsäureanhydrid, Mesaconsäureanhydrid, Citraconsäureanhydrid oder Methylenmalonsäureanhydrid, insbesondere Malein- und Itaconsäureanhydrid, bevorzugt. Geeignete Bedingungen zur Herstellung der Copolymere sind ausführlich in der EP-A 0 367 049 beschrieben. Von den ethylenisch ungesättigten (C₃-C₈)Carbonsäuren (IIb) sind Acrylsäure und Methacrylsäure bevorzugt, da sie großtechnisch verfügbar sind.

Ihre spezifischen emulgierenden Eigenschaften erhalten die Copolymere erst durch die Teilveresterungen ihrer Carboxygruppen mit den genannten Umsetzungsprodukten aus den Verbindungen (A) und (B). Es handelt sich dabei bevorzugt um Veretherungsprodukte aus (C₁-C₃₀)Alkoholen oder sekundären (C₂-C₃₀)Aminen (A), an die Polyalkylenoxid-Ketten aus 3 bis 30 (C₂-C₄)Alkylenoxid-Einheiten (B), bevorzugt Ethylen- und Propylenoxid oder Mischungen der beiden, angelagert sind. Verbindungen dieser Art, die am Polyalkylenoxid-Kettenende eine OH-Gruppe tragen, sind als nichtionische Tenside gängige Handelsprodukte (beispielsweise Ethoxylate/Propoxylate von Fettalkoholen, -säuren, -amiden, -aminen).

Um zu gut wasserlöslichen Substanzen zu gelangen, werden die im partiell veresterten Copolymer nach der Hydrolyse verbliebenen Carboxylgruppen durch Umsetzung mit Alkali, Ammoniak und/oder Alkanolaminen neutralisiert, so daß letztendlich wäßrige Lösungen mit pH-Werten von 4 bis 10, vorzugsweise von 6 bis 8 erhalten werden. Zur Neutralisation werden bevorzugt wäßrige NaOH- oder KOH-Lösungen eingesetzt.

### Allgemeine Synthesevorschrift für Copolymere mit Einheiten aus ethylenisch ungesättigten Dicarbonsäureanhydriden (IIa):

In einem mit Rührer, Thermometer, Kühler, Stickstoffein- und -auslaß sowie Dosiervorrichtungen versehenen Polymerisationsreaktor wurden ein Olefin oder eine Olefinmischung (I) und ein ethylenisch ungesättigtes Dicarbonsäureanhydrid (IIa) (s. Tabelle 1) sowie Polyvinylethylether mit einem K-Wert von 50 vorgelegt und in einem schwachen Stickstoffstrom auf 100°C erhitzt. Sobald die Temperatur erreicht war, wurden innerhalb von 1 bis 3 Stunden 1 mol-% *tert*.-Butylperoxy-2-ethyl-hexanoat (30 Gew.-% in dem Olefin oder der Olefinmischung) zugegeben. Das Reaktionsgemisch wird noch weitere 2 bis 4 Stunden auf 100°C erhitzt. Man erhielt eine klare Lösung des Copolymers in dem Olefin. Nicht umgesetztes Olefin wurde anschließend unter vermindertem Druck abdestilliert.

**Tabelle 1**

| Polymer | Monomer I | Molanteil* | Monomer IIa | Molanteil | K-Wert ** |
|---|---|---|---|---|---|
| A | Dodecen | 4 | Maleinsäureanhydrid | 6 | 9 |
| B | Diisobuten | 5 | Maleinsäureanhydrid | 5 | 13 |
| C | Diisobuten | 6 | Itaconsäureanhydrid | 4 | 25 |

| | | | | | |
|---|---|---|---|---|---|
| * Molarer Anteil an Monomereinheiten im Ausgangsmonomeren-Gemisch | | | | | |
| ** K-Wert bestimmt nach der Methode von H. Fikentscher, Cellulose Chemie, Band 13 [1932], Seiten 58 bis 64 und 71 bis 74, gemessen in Tetrahydrofuran bei einer Temperatur von 25°C und einer Polymerkonzentration von 1 Gew.-%. | | | | | |

### Synthesebeispiel für die partielle Veresterung der Copolymere aus den Komponenten (I) und (IIa) (Polymere 1-6):

Die oben beschriebenen Copolymere wurden mit einem Anlagerungsprodukt aus der Umsetzung von Ethylenoxid mit einem Oxoalkohol in Gegenwart von *para*-Toluolsulfonsäure innerhalb von 2 bis 12 Stunden unter Kochen am Rückfluß umgesetzt. Das Reaktionsgemisch wurde dann auf 100°C abgekühlt. Anschließend wurde Wasser und gegebenfalls wäßrige Alkali- oder Erdalkalilösung zugegeben und weitere 2 Stunden bei 50°C bis 70°C gerührt. Es entstanden dabei hellbraune, viskose Lösungen.

**Tabelle II**

| 1 | 2 | 3 | 4 | 5 | 6 | 7 | 8 |
|---|---|---|---|---|---|---|---|
| 1 | A | 25 | 1 mol C₁₃/C₁₅-Oxoalkohol + 7 mol Ethylenoxid (EO) | MgOH | 49,8 | 8,4 | 10,2 |
| 2 | A | 10 | 1 mol C₁₀-Oxoalkohol + 10 mol EO | KOH | 53,1 | 7,0 | 13,2 |
| 3 | B | 15 | 1 mol C₁₃/C₁₅-Oxoalkohol + 5 mol EO | NaOH | 48,7 | 7,2 | 16,2 |
| 4 | B | 12,5 | 1 mol C₁₃/C₁₅-Oxoalkohol + 7 mol EO | KOH | 45,1 | 7,1 | 14,8 |
| 5 | C | 32,5 | 1 mol C₁₂/C₁₄-Oxoalkohol + 8 mol EO | NaOH | 49,2 | 7,4 | 23,1 |
| 6 | C | 10 | 1 mol Methanol + 15 mol EO | KOH | 51,0 | 7,1 | 19,9 |

| | | | | | | | |
|---|---|---|---|---|---|---|---|
| 1 Polymer | | | | | | | |
| 2 Ausgangscopolymer | | | | | | | |
| 3 Anteil der zu Ester umgesetzten COOH-Gruppen in % | | | | | | | |
| 4 Verbindung erhältlich durch Alkoxylierung von | | | | | | | |
| 5 eingesetzte Base | | | | | | | |
| 6 Feststoffgehalt der wäßrigen Lösung | | | | | | | |
| 7 pH-Wert | | | | | | | |
| 8 K-Wert des Produktes | | | | | | | |

### Synthesebeispiel für Copolymere mit Monomereinheiten aus (IIb) (Polymer 7):

Diisobuten, Acrylsäure und das Umsetzungsprodukt aus 7 mol Ethylenoxid mit 1 mol C₁₃/C₁₅-Oxoalkohol und Acryloylchlorid wurden im Molverhältnis 5:3:2 in dem oben beschriebenen Polymerisationsreaktor auf 100°C erhitzt. Innerhalb von 3 Stunden wurde 1 mol-% *tert*.-Butylperoxy-2-ethyl-hexanoat (30 Gew.-% in Diisobuten) zudosiert und weitere 3 Stunden bei 100°C gerührt. Das überschüssige Olefin wurde dann unter vermindertem Druck abdestilliert und der Destillationsrückstand mit wäßriger Kaliumhydroxid-Lösung versetzt, so daß eine viskose Lösung mit einem Feststoffgehalt von 51,1 % und einem pH von 7,3 resultierte. Der K-Wert des Copolymerisats betrug 25,7 (bestimmt nach der Methode von H. Fikentscher bestimmt in wäßriger Lösung bei 25°C, pH = 7,5 und einer Polymerkonzentration von 1 Gew.-%).

Der erfingdungsgemäß verwendete wäßrig-alkalische Entwickler enthält in gebrauchsfertiger Form mindestens eines der beschriebenen, als Emulgator wirkenden Copolymere in einem Anteil von 0,1 bis 10,0 Gew.-%, insbesondere 0,2 bis 8,0 Gew.-% und bevorzugt 0,5 bis 6,0 Gew.-%, jeweils bezogen auf das Gesamtgewicht des gebrauchsfertigen Entwicklers.

Der gemäß der vorliegenden Erfindung verwendete Entwickler eignet sich besonders zum Entwickeln von Aufzeichnungsmaterialien mit einer negativ arbeitenden strahlungsempfindlichen Schicht. Er enthält dann zusätzlich noch mindestens ein mit Wasser mischbares organisches Lösemittel und mindestens eine oberflächenaktive Verbindung (Tensid).

Die alkalisch reagierende Verbindung ist bevorzugt ein Alkanolamin, ein Hydroxid, ein Phosphat oder ein Carbonat. Bevorzugte Alkanolamine sind Ethanolamin, Di- und Triethanolamin, Isopropanolamin, Diisopropanolamin sowie Tris-(hydroxymethyl)-aminomethan. Bevorzugte Hydroxide sind Alkali- und Erdalkalimetallhydroxide sowie Di-, Tri- und Tetra(C₁-C₁₀)alkylammoniumhydroxide. Bevorzugte Carbonate sind Natrium-, Kalium- und Ammoniumcarbonate oder -hydrogencarbonate. Von allen alkalisch reagierenden Verbindungen sind die Alkanolamine und Alkalimetallhydroxide am besten geeignet.

Der Anteil der alkalisch reagierenden Verbindung(en) ist auf die Art des Aufzeichnungsmaterials abzustimmen. Er liegt in der Regel bei 0,1 bis 20 Gew.-%, insbesondere 0,5 bis 10 Gew.-% und vorzugsweise 1,0 bis 5,0 Gew.-%, jeweils bezogen auf das Gesamtgewicht des gebrauchsfertigen Entwicklers. Bei flüssigen Konzentraten liegt der Anteil entsprechend höher. Im allgemeinen beträgt der pH-Wert des gebrauchsfertigen erfindungsgemäßen Entwicklers 8,0 bis 13,0, bevorzugt 8,5 bis 11,5.

Als "mischbar mit Wasser'' wird im Zusammenhang mit der vorliegenden Erfindung ein organisches Lösemittel bezeichnet, das in der verwendeten Menge (bis zu 20 Gew.-%) bei einer Temperatur, bei der Entwickler normalerweise gelagert oder verwendet werden (etwa 0 bis 60 °C), mit Wasser eine einheitliche Lösung bildet. Besonders kurze Entwicklungszeiten werden erreicht durch Zusatz eines oder mehrerer der folgenden organischen Lösemittel: Alkohole, speziell Benzylalkohol, Ethylenglykolmonophenylether, 1-Phenylethanol, 2-Phenylethanol, Propylenglykolmonomethyl- und - phenylether, sowie Glycerin oder Glycerinacetate. Der Anteil an organischem Lösemittel im gebrauchsfertigen Entwickler beträgt zweckmäßig 0,5 bis 15,0 Gew.-%, insbesondere 1,0 bis 10,0 Gew.-% und bevorzugt 2,0 bis 6,0 Gew.-%, jeweils bezogen auf das Gesamtgewicht des Entwicklers. Da nur relativ geringe Anteile an organischem Lösemittel im Entwickler vorhanden sind, ändert sich seine Zusammensetzung während des Gebrauchs praktisch nicht. Er hat somit in den Entwicklungsgeräten eine verhältnismäßig lange Standzeit.

Als Tenside eignen sich im erfindungsgemäßen Entwickler viele anionische oberflächenaktive Mittel. Darüber hinaus können Gemische aus anionischen mit nichtionischen und/oder zwitterionischen oberflächaktiven Substanzen erfolgreich eingesetzt werden. Bewährt haben sich vor allem anionische Tenside wie Alkali-, vorzugsweise Natrium-, -octylsulfate, -dodecylbenzolsulfonate, -alkylphenolethersulfate, -naphthalinsulfonate, -sulfosuccinate und -alkyletherphosphate. Geeignete nichtionische Tenside stammen aus den Substanzklassen der (C₁₀-C₁₈)-Fettalkoholethoxylate, Polyethylenglykole, Ethylenoxid-Propylenoxid-(Block-)Copolymerisate und Alkylphenolethoxylate sowie der zwitterionischen Tenside vom Betain- oder Sulfobetain-Typ und können 0 bis 80 Gew.-% der gesamten Tensidmenge ausmachen. Der Anteil der oberflächenaktiven Substanz(en) in dem Entwickler beträgt allgemein 0,2 bis 12,0 Gew.-%, bevorzugt 0,5 bis 8,0 Gew.-%, besonders bevorzugt 1,0 bis 6,0 Gew.-%, jeweils bezogen auf das Gesamtgewicht des Entwicklers.

Der erfindungsgemäß verwendete Entwickler kann darüber hinaus je nach Art der zu verarbeitenden Aufzeichnungsmaterialien weitere Additive enthalten, insbesondere Puffersubstanzen, Komplexbildner (speziell solche, die Calcium binden), Entschäumer oder Sequestrierhilfsmittel.

Als Puffersubstanzen haben sich in dem erfindungsgemäß verwendeten Entwickler n-Alkansäuren mit 6 bis 12 C-Atomen und/oder deren Salze, besonders Capryl-, Pelargon-, Caprin- und Laurinsäure, bewährt. Im gebrauchsfertigen Entwickler können diese Säuren in einem Anteil von 0,5 bis 8,0 Gew.-%, insbesondere 1,0 bis 6,5 Gew.-% vorliegen, bezogen auf das Gesamtgewicht des Entwicklers.

Als puffernde Systeme sind grundsätzlich alle diejenigen geeignet, die vorzugsweise im pH-Bereich von 8 bis 13 wirksam sind. Neben den genannten n-Alkansäuren und deren Salzen werden jedoch vor allem die allgemein zugänglichen Puffersubstanzen aus der Gruppe der Carbonate, Phospate, Borate, Alkalisalze des Glycins und Amine verwendet. Sehr gebräuchliche Puffersysteme sind beispielsweise die Mischungen aus Carbonat/Hydrogencarbonat oder Phosphat/Hydrogenphosphat.

Als Komplexbildner sind die Salze niedermolekularer Phosphate, sogenannte Oligophosphate, mit 2 bis 10, vorzugsweise 2 bis 6, insbesondere 2 bis 4, Phosphoreinheiten einsetzbar. Besonders bevorzugt sind die Alkalisalze, insbesondere die Natrium- und Kaliumsalze, darunter z. B. Tetranatriumdiphosphat, Pentanatriumtriphosphat, Pentakaliumtriphosphat und Hexanatriumtetraphosphat.

Gute Ergebnisse zeigen auch Alkalisalze, vorzugsweise Natriumsalze, der Nitrilotriessigsäure und der Ethylendiamintetraessigsäure, sowie Tris-hydroxymethylaminomethan. Der Gehalt an Komplexbildnern im gebrauchsfertigen Entwickler beträgt zweckmäßig 0,1 bis 5,0 Gew.-%, insbesondere 0,5 bis 4,0 Gew.-% und vorzugsweise 1,0 bis 3,0 Gew.-%.

Der Wasseranteil in dem Entwickler besteht vorzugsweise aus entionisiertem Wasser und beträgt in der gebrauchsfertigen Form 70 bis 95 Gew.-%, bevorzugt 75 bis 90 Gew.-%.

Darüber hinaus kann der erfindungsgemäße Entwickler auch als Konzentrat formuliert werden. Der Anteil an nichtwäßrigen Komponenten ist darin bis zum Dreifachen der genannten Mengen gesteigert. Auch solche Konzentrate zeigen keine störende Geruchsbelästigung, und es treten auch nach Lagerung bei Temperaturen um den Gefrierpunkt keine Ausfällungen auf.

In den Geräten zur Entwicklung von Aufzeichnungsmaterialien sind üblicherweise Entwickler-, Spül- und Gummierstation hintereinander geschaltet. Mit steigender Belastung des Entwicklers mit Schichtbestandteilen kommt es zu einer langsameren und nicht mehr vollständigen Aufentwicklung. Beim Spülen ist es kaum zu vermeiden, daß wirksame Entwicklerbestandteile selektiv entfernt werden, so daß Schichtbestandteile aus der verschleppten Entwicklerlösung an der Oberfläche des Aufzeichnungsmaterials in agglomerierter Form adsorbiert werden und sich dort als unerwünschte Verunreinigungen bemerkbar machen können. Diese adsorbierten Schichtbestandteile werden von der Gummierlösung nicht aufgelöst und weggespült, sondern nur von der Trägeroberfläche als Häutchen abgehoben ("Fädchenbildung"). Dieses Phänomen wird durch den erfindungsgemäßen Entwickler wirkungsvoll verzögert, ohne daß gleichzeitig mit einer erheblichen Erhöhung der Entwicklerviskosität bei zunehmender Belastung mit Schichtbestandteilen zu rechnen ist, was wiederum dazu beiträgt, die Menge an verschlepptem Entwickler geringzuhalten.

Der erfindungsgemäß verwendete Entwickler eignet sich grundsätzlich für die Verarbeitung einer Reihe von positiv und negativ arbeitenden Aufzeichnungsmaterialien. Dabei können die negativ arbeitenden Materialien entsprechend der Art der strahlungsempfindlichen Schicht eingeteilt werden in solche
1. mit einer negativ arbeitenden Schicht auf Basis von Diazoniumsalz-Polykondensationsverbindungen,
2. mit einer negativ arbeitenden Schicht, die radikalisch polymerisierbare, olefinisch ungesättigte Verbindungen und Photopolymerisationsinitiatoren enthält, und
3. die auf einer Kombinationen der unter 1. und 2. genannten Prinzipien aufbauen.

Eine negativ arbeitende Schicht auf Basis von Diazoniumsalz-Polykondensationsverbindungen enthält beispielsweise Kondensationsprodukte von Diphenylamin-4-diazoniumsalzen mit Aldehyden, bevorzugt Formaldehyd. Mit besonderem Vorteil werden Mischkondensationsprodukte verwendet, die außer den Diazoniumsalz-Einheiten noch andere, nicht lichtempfindliche Einheiten enthalten, die von kondensationsfähigen Verbindungen, insbesondere aromatischen Aminen, Phenolen, Phenolethern, aromatischen Thioethern, aromatischen Kohlenwasserstoffen, aromatischen Heterocyclen und organischen Säureamiden abgeleitet sind. Geeignete Diazoniumsalz-Kondensationsprodukte dieser Art sind in den DE-A 20 24 244 und in der DE-A 27 39 774 beschrieben.

Zur Stabilisierung des lichtempfindlichen Gemisches ist es vorteilhaft, diesem eine Verbindung mit Säurecharakter zuzusetzen. In Betracht kommen Mineralsäuren und starke organische Säuren, von denen Phosphorsäure, Schwefelsäure, Perchlorsäure, Borsäure oder *para*-Toluolsulfonsäure bevorzugt werden. Eine besonders gut geeignete Säure ist die *ortho*-Phosphorsäure.

Ein weiterer Hauptbestandteil von negativ arbeitenden Schichten vom Typ 1 ist mindestens ein nicht lichtempfindliches polymeres Bindemittel mit seitenständigen Carboxygruppen, das in wäßrig-alkalischen Lösungen löslich oder mindestens quellbar ist. Dieses Bindemittel kann beispielsweise das Umsetzungsprodukt eines intramolekularen Anhydrids einer organischen Polycarbonsäure mit einem Hydroxygruppen enthaltenden synthetischen Polymeren sein, das keine weiteren zur Umsetzung mit Säureanhydriden befähigten funktionellen Gruppen enthält. Funktionalisierte Bindemittel dieser Art sind in der DE-A 34 04 366 ausführlich beschrieben.

Den lichtempfindlichen Gemischen können ferner Weichmacher, Haftvermittler, Farbstoffe, Pigmente und photochemische Farbbildner zugesetzt sein.

Die negativ arbeitende Schicht vom Typ 2 enthält bevorzugt eine Kombination aus einem radikalisch polymerisierbaren, ethylenisch ungesättigten Monomer, insbesondere einem Acryl- oder Methacrylsäureester eines mehrwertigen Alkohols, und einem Photoinitiator. In diesen Schichten werden als alkalilösliche Bindemittel bevorzugt Polykondensate oder Polymere mit seitenstädigen Carboxygruppen verwendet.

Vorzugsweise sind negativ arbeitende Schichten durch ein Deckschicht ("overcoat") geschützt, insbesondere vor dem Zutritt von Luftsauerstoff. Dazu enthält die Deckschicht üblicherweise Polymere, die eine verminderte Sauerstoffdurchlässigkeit bewirken. Besonders geeignet für diesen Zweck sind Polyvinylalkohol, Polyvinylpyrrolidon oder Gelatine.

Der erfindungsgemäß verwendete Entwickler ist auch für Aufzeichnungsmaterialien mit einer positiv arbeitenden strahlungsempfindlichen Schicht geeignet. Der Anteil des organischen Lösemittels muß dann allerdings relativ gering sein, damit die Bildbereiche nicht zu stark angegriffen werden.

Als Trägermaterial für Schichten mit einer Dicke unter ca. 10 µm werden meist Metalle verwendet. Für Offsetdruckplatten nimmt man gewöhnlich walzblankes, mechanisch und/oder elektrochemisch aufgerauhtes und gegebenenfalls anodisiertes Aluminium, das zudem noch chemisch (beispielsweise mit Polyvinylphosphonsäure, Silikaten, Phosphaten oder Hexafluorozirkonaten) vorbehandelt sein kann.

Die Beschichtung des Trägermaterials erfolgt in bekannter Weise durch Aufschleudern, Sprühen, Tauchen, Walzen, mittels Breitschlitzdüsen, Rakeln oder durch Gießer-Antrag.

Nach dem Auftragen der Schicht wird das Aufzeichnungsmaterial je nach Schichttyp bildmäßig und gegebenenfalls vollflächig bestrahlt. Übliche Strahlungsquellen sind anwendungsbedingt z. B. Röhrenlampen, Xenonimpulslampen, metallhalogeniddotierte Quecksilberdampf-Hochdrucklampen und Kohlebogenlampen. In automatischen Verarbeitungsanlagen sind Laser, wie Argon- oder Krypton-Ionen-Laser bevorzugt. Auch Elektronen- oder Röntgenstrahlung kann zur Bilderzeugung verwendet werden.

Die anschließende Entwicklung mit den vorgenannten Entwicklern erfolgt meist in Sprüh-, Stau- oder Tauchbad-Entwicklungsgeräten bei Temperaturen von 15 bis 50°C, bevorzugt 18 bis 40°C. Die Entwicklungsdauer beträgt im allgemeinen 5 s bis 1 min, bevorzugt 10 bis 40 s.

An die Entwicklung können sich weitere Verarbeitungsschritte anschließen. Beispielsweise können Druckplatten mit einer (sauren) Hydrophilierungslösung behandelt oder mit einer Konservierungsschicht versehen werden. Zur Erhöhung der Widerstandsfähigkeit beim Druck sowie der Resistenz gegen Auswaschmittel, Korrekturmittel und UV-härtbare Druckfarben können die entwickelten Platten kurzzeitig erhitzt werden. Vor dem Erhitzen können auch sogenannte Einbrenngummierungen aufgetragen werden.

Die folgenden Ausführungsbeispiele sollen die Erfindung erläutern. Gt bedeutet Gewichtsteil(e).

### A) Negativ arbeitendes Aufzeichnungsmaterial (Diazo):

Eine Beschichtungslösung aus

| | |
|---|---|
| 1,50 Gt | eines Polymeren, hergestellt durch Erhitzen einer Lösung eines Polyvinylbutyrals (enthält 71 Gew.-% Vinylbutyral-, 3 Gew.-% Vinyl-acetat- und 26 Gew.-% Vinylalkohol-Einheiten; Molekulargewicht M_{W} 70.000 bis 80.000) mit Maleinsäureanhydrid und Triethylamin in Methylethylketon unter Rückfluß, |
| 1,00 Gt | eines Diazoniumsalz-Polykondensationsproduktes aus 1 mol 3-Methoxy-diphenylamin-4-diazoniumsulfat und 1 mol 4,4'-Bis-methoxymethyl-diphenylether, ausgefällt als Mesitylensulfonat, |
| 0,09 Gt | Victoriareinblau FGA (Basic Blue 81), |
| 0,07 Gt | Benzolphosphonsäure, |
| 0,10 Gt | eines Kieselgelfüllstoffs mit einer mittleren Korngröße von 3 µm und |
| 97,24 Gt | eines Gemisches aus Tetrahydrofuran und Ethylenglykolmonomethylether (40:60) |

wurde auf eine in Salzsäure aufgerauhte, in Schwefelsäure anodisierte und mit einer wäßrigen Polyvinylphosphonsäure-Lösung nachbehandelte Aluminiumfolie so aufgetragen, daß nach 2 min Trocknen bei 100°C das Schichtgewicht 1,0 g/m² betrug.

Mit der Beschichtungslösung hergestellte negativ arbeitende Aufzeichnungsmaterialien wurden in einem Kontaktkopierrahmen durch eine Negativ-Filmvorlage unter einer 5-kW-Metallhalogenidlampe im Abstand von 110 cm 30 s lang belichtet und dann in einem Sprüh-Entwicklungsgerät bei 24°C und einer Verarbeitungsgeschwindigkeit von 1,4 m/min (= 20 s Entwicklungszeit) entwickelt. Die Gummierstation wurde mit einer handelsüblichen Gummierung gefüllt (AGFA ®Ozasol RC 795).

### B) Entwickler:

In Tabelle IIIa werden verschiedene Entwickler verglichen. Die Entwickler A, B und K dienen zu Vergleichszwecken, da sie andere polymere Emulgatoren als die erfindungsgemäßen Entwickler enthalten.

Tabelle IIIb enthält die Versuchsergebnisse im Vergleich. Die mit dem erfindungsgemäßen Entwickler entwickelten Platten waren in allen Fällen frei von Schleier, die Volltöne ohne Ausbrüche oder sonstige Schädigungen durch Schichtabtrag wiedergegeben, das 60er Raster mit einer Flächendeckung von 2 bis 98 %. Entwickelt wurde jeweils bis zu einer Endbelastung von 20 m²/l.

Ausgewertet wurden daneben folgende Meßgrößen:
- Viskosität der Entwicklerlösung vor und nach Abschluß des Belastungsversuchs;
- Plattenfläche pro Liter an Entwickler [m²/l], bis zu der redeposit-freie Entwicklung problemlos möglich ist.

Tabelle IIIb zeigt, daß die erfindungsgemäßen Entwickler entweder
- bei vergleichbarer Entwicklungsleistung (bis zum Auftreten von Schicht-Redeposits nach Gummierung) einen meßbar geringeren Viskositätsanstieg zeigen, oder daß sie
- darüber hinaus bei vergleichbarer bzw. sogar gegenüber den Vergleichsbeispielen geringerer Viskositätszunahme eine günstigere Entwicklungsleistung aufweisen.

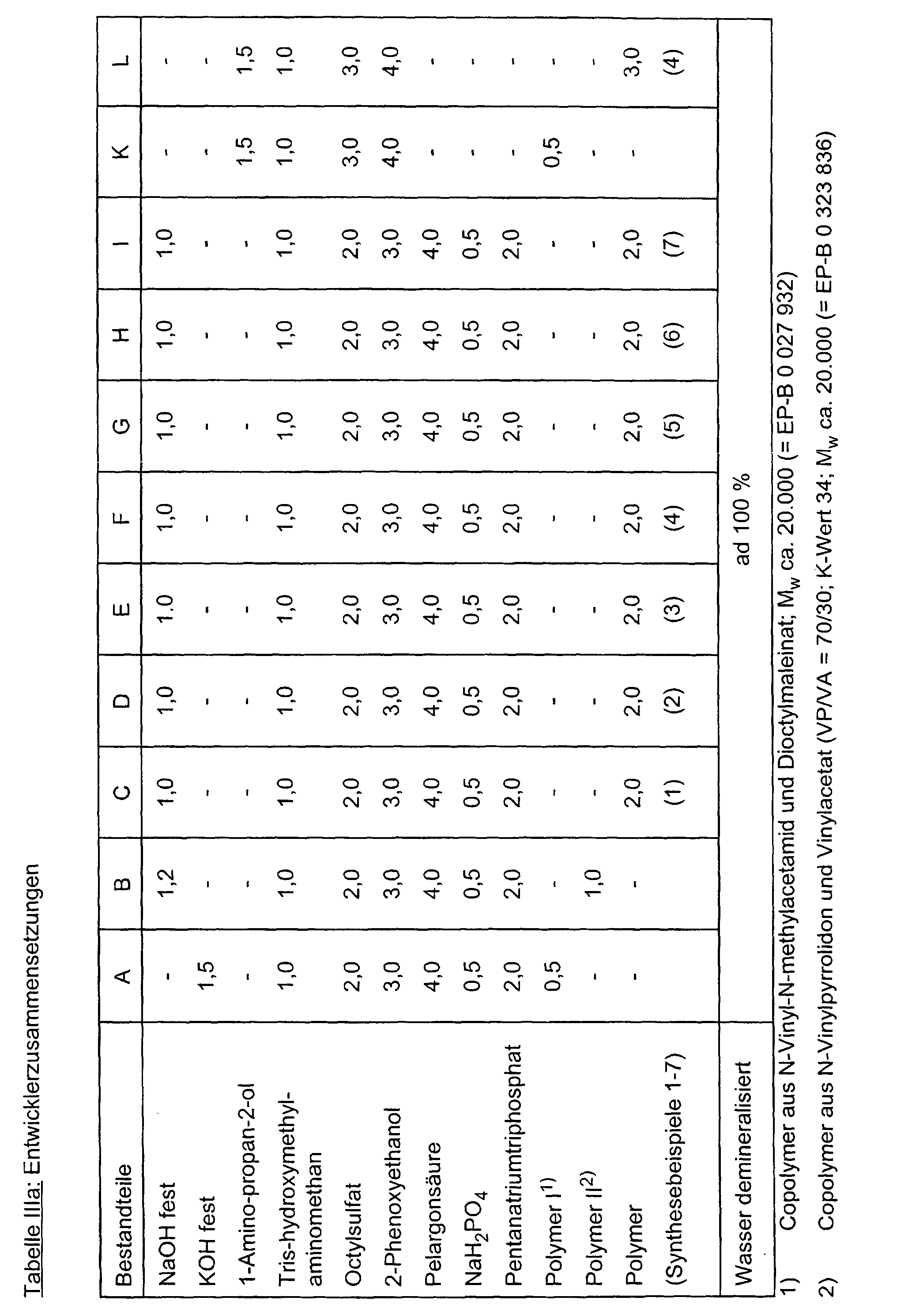

**Tabelle IIIb:**

| Entwickler formulierung | Viskosität (mm²/s) | | redepositfrei entwickelbare Plattenfläche (m²/l) |
|---|---|---|---|
| | frisch | nach 20 m²/l | |
| A* | 2,6224 | 4,0320 | 13,0 |
| B* | 2,1909 | 3,3693 | 6,0 |
| C | 1,6054 | 2,5087 | 13,5 |
| D | 1,7896 | 2,7134 | 14,5 |
| E | 1,9783 | 3,1375 | 13,0 |
| F | 1,8245 | 2,8353 | 17,5 |
| G | 2,1079 | 3,5076 | 16,5 |
| H | 1,9985 | 2,9854 | 13,0 |
| I | 1,8085 | 2,9023 | 12,5 |
| K* | 2,2086 | 3,9680 | 10,5 |
| L | 1,8718 | 2,8897 | 15,0 |

| | | | |
|---|---|---|---|
| * Vergleichsbeispiele | | | |

## Patentansprüche

1. Verwendung einer Zusammensetzung, die Wasser und mindestens eine in wäßriger Lösung alkalisch reagierende Verbindung enthält, als Entwickler zum Entwickeln von bestrahlten, strahlungsempfindlichen Aufzeichnungsmaterialien, **dadurch gekennzeichnet, daß** die Zusammensetzung mindestens ein als Emulgator wirkendes Copolymer mit Einheiten enthält aus
(I) mindestens einer hydrophoben Vinylverbindung, die Alkylreste mit bis 30 Kohlenstoffatomen aufweist, und
(II) mindestens einer hydrophilen, ethylenisch ungesättigten Carbonsäure, wobei ein Teil der Carboxygruppen in diesen Einheiten verestert ist mit Umsetzungsprodukten von
(A) (C₁-C₃₀)Alkanolen, (C₈-C₂₅)Alkansäuren, (C₁-C₁₂)Alkyl-phenolen, Di(C₁-C₂₀)alkylaminen mit
(B) (C₂-C₄)Alkylenoxiden oder Tetrahydrofuran
wobei das Molverhältnis (A) : (B) im Bereich von 1 : 2 bis 1 : 50 liegt.

2. Verwendung einer Zusammensetzung gemäß Anspruch 1, **dadurch gekennzeichnet, daß** 5 bis 50 % der Carboxygruppen der ethylenisch ungesättigten Carbonsäuren(II) verestert sind.

3. Verwendung einer Zusammensetzung gemäß Anspruch 1 oder 2, **dadurch gekennzeichnet, daß** die Einheiten (I) und (II) zusammen mindestens 50 mol-%, aller Monomereinheiten im Copolymer ausmachen, wobei die Einheiten (II) einen Anteil von mindestens 5 mol-%, ausmachen.

4. Verwendung einer Zusammensetzung gemäß einem oder mehreren der Ansprüche 1 bis 3, **dadurch gekennzeichnet, daß** das als Emulgator wirkende Copolymer erhältlich ist durch Copolymerisation von (I) mindestens einem (C₄-C₂₈)Alken und
(IIa) mindestens einem ethylenisch ungesättigten Dicarbonsäureanhydrid mit 4 bis 8 C-Atomen, wobei das Molverhältnis (I) : (IIa) im Bereich von 7:3 bis 3:7 liegt, oder
(IIb) mindestens einer ethylenisch ungesättigten Monocarbonsäure mit 3 bis 8 C-Atomen, wobei das Molverhältnis (I) : (IIb) im Bereich 1 : 1 bis 1 : 5 liegt,
anschließender partieller Veresterung des Copolymers mit Umsetzungsprodukten von
(A) (C₁-C₃₀)Alkanolen, (C₈-C₂₂)Fettsäuren, (C₁-C₁₂)Alkyl-phenolen oder sekundären (C₂-C₃₀) Aminen mit
(B) mindestens einem (C₂-C₄)Alkylenoxid oder Tetrahydrofuran, wobei das Molverhältnis (A):(B) im Bereich von 1:2 bis 1:50 liegt,
und Hydrolyse der Anhydridgruppen der Copolymere zu Carboxygruppen oder deren Salzen, wobei die partielle Veresterung der Copolymere so weit geführt wird, daß zwischen 5 und 50 % der Carboxygruppen des Copolymers verestert sind.

5. Verwendung einer Zusammensetzung gemäß einem oder mehreren der Ansprüche 1 bis 4, **dadurch gekennzeichnet, daß** das als Emulgator wirkende Copolymer zusätzlich bis zu 50 mol-% an Einheiten enthält aus Amiden von monoethylenisch ungesättigten (C₃-C₈)Carbonsäuren, deren Amidgruppen der Formel
-CO-N(R¹)(R²).
entsprechen, worin
R¹ eine (C₈-C₂₈)Alkylgruppe oder eine Gruppe der Formel RO-[CHR³-CHR⁴-O]ₙ₋₁-CHR³₋CHR⁴- und
R² ein Wasserstoffatom oder eine der Gruppen R¹ bedeutet,
R³, R⁴ gleich oder verschieden sind und ein Wasserstoffatom eine Methyl- oder eine Ethylgruppe bedeuten,
R eine (C₁-C₂₈)Alkylgruppe und
n eine ganze Zahl von 2 bis 100 bedeutet.

6. Verwendung einer Zusammensetzung gemäß einem oder mehreren der Ansprüche 1 bis 5, **dadurch gekennzeichnet, daß** die Copolymere ein mittleres Molekulargewicht M_{w} von 500 bis 500.000 aufweisen.

7. Verwendung einer Zusammensetzung gemäß einem oder mehreren der Ansprüche 1 bis 6, **dadurch gekennzeichnet, daß** der Anteil der Copolymere bezogen auf das Gesamtgewicht der Zusammensetzung 0,1 bis 10,0 Gew.-% beträgt.

8. Verwendung einer Zusammensetzung gemäß einem oder mehreren der Ansprüche 1 bis 7, **dadurch gekennzeichnet, daß** die Zusammensetzung zusätzlich ein mit Wasser mischbares organisches Lösemittel und mindestens eine oberflächenaktive Verbindung enthält.

9. Verwendung einer Zusammensetzung gemäß einem oder mehreren der Ansprüche 1 bis 8, **dadurch gekennzeichnet, daß** der Anteil des alkalisch wirkenden Mittels bezogen auf das Gesamtgewicht der Zusammensetzung 0,1 bis 20 Gew.-% beträgt.

10. Verwendung einer Zusammensetzung gemäß einem oder mehreren der Ansprüche 1 bis 9, **dadurch gekennzeichnet, daß** der pH-Wert der Zusammensetzung bei 8,0 bis 13,0 liegt.

11. Verwendung einer Zusammensetzung gemäß einem oder mehreren der vorstehenden Ansprüche zur Entwicklung von Aufzeichnungsmaterialien mit einer negativ arbeitenden Schicht.

12. Verwendung einer Zusammensetzung gemäß Anspruch 11, wobei die negativ arbeitende Schicht als strahlungsempfindliche Komponente (a) eine Diazoniumsalz-Polykondensationsverbindung, (b) eine Kombination aus radikalisch polymerisierbaren, ethylenisch ungesättigten Verbindungen und Photoinitiatoren oder (c) eine Mischung aus (a) und (b) enthält.

13. Verwendung einer Zusammensetzung gemäß einem der Ansprüche 11 oder 12, **dadurch gekennzeichnet, daß** die negativ arbeitende Schicht ein Bindemittel enthält.

14. Verwendung einer Zusammensetzung gemäß Anspruch 13, wobei es sich bei dem Bindemittel um ein Umsetzungsprodukt eines intramolekularen Anhydrids einer organischen Polycarbonsäure mit einem Hydroxylgruppen enthaltenden synthetischen Polymer, das keine weiteren zur Umsetzung mit Säureanhydriden befähigten funktionellen Gruppen enthält handelt.

## Claims

1. Use of a developer composition for the development of exposed, photosensitive recording materials which contains water and at least one compound which is alkaline in an aqueous solution, **characterized in that** the said composition contains at least one copolymer acting as an emulsifier and comprising units of
(I) at least one hydrophobic vinyl compound which has alkyl radicals having up to 30 carbon atoms and
(II) at least one hydrophilic, ethylenically unsaturated carboxylic acid, some of the carboxyl groups in these units being esterified with reaction products of
(A) (C₁-C₃₀)alkanols, (C₈-C₂₅)alkanoic acids, (C₁-C₁₂)-alkylphenols or di (C₁-C₂₀) alkylamines with
(B) (C₂-C₄)alkylene oxides or tetrahydrofuran,
the molar ratio (A) :(B) being in the range from 1:2 to 1:50.

2. Use of a composition according to claim 1, wherein from 5 to 50% of the carboxyl groups of the ethylenically unsaturated carboxylic acids (II) have been esterified.

3. Use of a composition according to claim 1 or 2, wherein the units (I) and (II) together account for at least 50 mol% of all monomer units in the copolymer, the units (II) accounting for an amount of at least 5 mol%.

4. Use of a composition according to one or more of claims 1 to 3, wherein the copolymer acting as emulsifier is obtainable by copolymerization of (I) at least one (C₄-C₂₈)alkene and
(IIa) at least one ethylenically unsaturated dicarboxylic anhydride having 4 to 8 carbon atoms, the molar ratio (I):(IIa) being in the range from 7:3 to 3:7, or
(IIb) at least one ethylenically unsaturated monocarboxylic acid having 3 to 8 carbon atoms, the molar ratio (I):(IIb) being in the range from 1:1 to 1:5,
subsequent partial esterification of the copolymer with reaction products of
(A) (C₁-C₃₀)alkanols, (C₈-C₂₂)fatty acids, (C₁-C₁₂)alkylphenols or secondary (C₂-C₃₀)amines with
(B) at least one (C₂-C₄)alkylene oxide or tetrahydrofuran, the molar ratio (A):(B) being in the range from 1:2 to 1:50, and hydrolysis of the anhydride groups of the copolymers to carboxyl groups or salts thereof, the partial esterification of the copolymers being continued until between 5 and 50% of the carboxyl groups of the copolymer have been esterified.

5. Use of a composition according to one or more of claims 1 to 4, wherein the copolymer acting as emulsifier additionally contains up to 50 mol% of units of amides of monoethylenically unsaturated (C₃-C₈)carboxylic acids the amido groups of which correspond to the formula
-CO-NR¹R²
in which
R¹ represents a (C₈-C₂₈)alkyl group or a group of the formula RO-(CHR³-CHR⁴-O_{]n-1}-CHR³-CHR⁴- and
R² represents a hydrogen atom or one of the groups R¹,
R³ and R⁴ are identical or different and represent a hydrogen atom, a methyl group or an ethyl group,
R represents a (C₁-C₂₈)alkyl group and
n is an integer from 2 to 100.

6. Use of a composition according to one or more of claims 1 to 5, wherein the copolymers have an average molecular weight M_{W} of from 500 to 500,000.

7. Use of a composition according to one or more of claims 1 to 6, wherein the amount of the copolymers is from 0.1 to 10.0% by weight, based on the total weight of the composition.

8. Use of a composition according to one or more of claims 1 to 7, wherein the composition additionally contains a water-miscible organic solvent and at least one surface-active compound.

9. Use of a composition according to one or more of claims 1 to 8, wherein the amount of the alkaline agent is from 0.1 to 20% by weight, based on the total weight of the composition.

10. Use of a composition according to one or more of claims 1 to 9, wherein the pH of the composition is from 8.0 to 13.0.

11. Use of a composition according to any of the preceding claims for developing recording materials having a negative-working layer.

12. Use of a composition according to claim 11, wherein the negative-working layer contains (a) a diazonium salt polycondensation compound, (b) a combination of ethylenically unsaturated radically polymerizable compounds and photoinitiators or (c) a mixture of (a) and (b) as photosensitive component.

13. Use of a composition according to any of claims 11 or 12, wherein the negative-working layer contains a binder.

14. Use of a composition according to claim 13, wherein the binder is a reaction product of an intramolecular anhydride of an organic polycarboxylic acid with a synthetic polymer containing hydroxyl groups, which contains no further functional groups capable of reacting with acid anhydrides.

## Revendications

1. Utilisation d'une composition contenant de l'eau et au moins un composé présentant une réaction alcaline en solution aqueuse en tant que révélateur pour le développement de matériaux d'enregistrement photosensibles exposés, **caractérisée en ce que** la composition contient au moins un copolymère à effet d'émulsifiant comprenant
(I) des unités d'au moins un composé vinylique hydrophobe présentant des radicaux d'alkyle possédant jusqu'à 30 atomes de carbone, et
(II) des unités d'au moins un acide carboxylique à insaturation éthylénique hydrophile, une partie des groupes carboxyle dans lesdites unités étant estérifiée avec les produits de réaction
(A) d'alcanols en C₁-C₃₀, d'acides alcanoïques en C₈-C₂₅, d'alkylphénols en C₁-C₁₂, de dialkylamines en C₁-C₂₀
(B) avec les oxydes d'alkylène en C₂-C₄ ou avec le tétrahydrofuranne
le rapport molaire de (A) à (B) étant compris entre 1 : 2 et 1 : 50.

2. Utilisation d'une composition selon la revendication 1, **caractérisée en ce que** 5 à 50 % des groupes carboxyle des acides carboxyliques (II) à insaturation éthylénique est estérifié.

3. Utilisation d'une composition selon la revendication 1 ou 2, **caractérisée en ce que** lesdites unités (I) et (II) constituent ensemble au moins 50 moles % de toutes les unités monomères dans le copolymère, les unités (II) constituant une quantité d'au moins 5 moles %.

4. Utilisation d'une composition selon l'une quelconque des revendications 1 à 3, **caractérisée en ce que** ledit copolymère à effet d'émulsifiant peut être obtenu par la copolymérisation (I) d'au moins un alcène en C₄-C₂₈ et
(IIa) d'au moins un anhydride dicarboxylique à insaturation éthylénique en C₄-C₈, le rapport molaire de (I) à (IIa) étant compris entre 7 : 3 et 3 : 7, ou
(IIb) d'au moins un acide monocarboxylique à insaturation éthylénique en C₃-C₈, le rapport molaire de (I) à (IIb) étant compris entre 1 : 1 et 1 : 5,
d'une estérification partielle subséquente du copolymère avec les produits de réaction
(A) d'alcanols en C₁-C₃₀, d'acides gras en C₈-C₂₂, d'alkylphénols en C₁-C₁₂ ou d'amines secondaires en C₂-C₃₀ avec
(B) au moins un oxyde d'alkylène en C₂-C₄ ou avec le tétrahydrofuranne, le rapport molaire de (A) à (B) étant compris entre 1 : 2 et 1 : 50,
et l'hydrolyse des groupes anhydride des copolymères en groupes carboxyle ou leurs sels, l'estérification partielle des copolymères étant poursuite jusqu'à ce que 5 à 50 % des groupes carboxyle du copolymère soit estérifié.

5. Utilisation d'une composition selon l'une quelconque des revendications 1 à 4, **caractérisée en ce que** ledit copolymère à effet d'émulsifiant contient en outre jusqu'à 50 moles % d'unités d'amides d'acides carboxyliques à insaturation monoéthylénique en C₃-C₈ dont les groupes amido répondent à la formule ci-après
-CO-NR¹R²,
dans laquelle
R¹ représente un groupe alkyle en C₈-C₂₈ ou un groupe répondant à la formule RO-[CHR³-CHR⁴-O]ₙ₋₁-CHR³-CHR⁴- et
R² représente un atome d'hydrogène ou l'un des groupes R¹,
R³, R⁴ sont identiques ou différents et représentent un atome d'hydrogène, un groupe méthyle ou éthyle,
R représente un groupe alkyle en C₁-C₂₈ et
n est un nombre entier de 2 à 100.

6. Utilisation d'une composition selon l'une quelconque des revendications 1 à 5, **caractérisée en ce que** lesdits copolymères présentent une masse moléculaire moyenne M_{W} de 500 à 500 000.

7. Utilisation d'une composition selon l'une quelconque des revendications 1 à 6, **caractérisée en ce que** la quantité des copolymères est de 0,1 à 10,0 % en poids par rapport au poids total de la composition.

8. Utilisation d'une composition selon l'une quelconque des revendications 1 à 7, **caractérisée en ce que** ladite composition contient en outre un solvant organique miscible à l'eau et au moins un composé tensioactif.

9. Utilisation d'une composition selon l'une quelconque des revendications 1 à 8, **caractérisée en ce que** la quantité dudit agent présentant une réaction alcaline est de 0,1 à 20 % en poids par rapport au poids total de la composition.

10. Utilisation d'une composition selon l'une quelconque des revendications 1 à 9, **caractérisée en ce que** le pH de la composition se situe dans la plage de 8,0 à 13,0.

11. Utilisation d'une composition selon l'une quelconque ou selon plusieurs des revendications précédentes pour le développement de matériaux d'enregistrement possédant une couche à effet négatif.

12. Utilisation d'une composition selon la revendication 11, **caractérisée en ce que** ladite couche à effet négatif contient en tant que constituant photosensible (a) un composé de polycondensation d'un sel de diazonium, (b) une combinaison de composés polymérisables par voie radicalaire à insaturation éthylénique et de photoamorceurs et (c) un mélange de (a) et (b).

13. Utilisation d'une composition selon la revendication 11 ou 12, **caractérisée en ce que** ladite couche à effet négatif contient un liant.

14. Utilisation d'une composition selon la revendication 13, **caractérisée en ce que** ledit liant est un produit de réaction d'un anhydride intramoléculaire d'un acide polycarboxylique et d'un polymère synthétique contenant des groupes hydroxyle, qui ne contient pas de groupes fonctionnels supplémentaires aptes à réagir avec des anhydrides acides.
